# FASCICULE DE BREVET EUROPEEN

(11) **EP 1 671 361 B1**
(45) Date de publication et mention de la délivrance du brevet: **04.04.2007**
(21) Numéro de dépôt: 04787425.0
(22) Date de dépôt: 23.09.2004
(51) Int. Cl.: H01L 21/20, C30B 33/02

(54) **PROCEDE DE FABRICATION D'UNE STRUCTURE EN FORME DE PLAQUE, EN PARTICULIER EN SILICIUM, APPLICATION DE PROCEDE, ET STRUCTURE EN FORME DE PLAQUE, EN PARTICULIER EN SILICIUM**
VERFAHREN ZUR HERSTELLUNG EINER PLATTENFÖRMIGEN STRUKTUR INSBESONDERE AUS SILIZIUM, VERWENDUNG DES VERFAHRENS UND DER SO HERGESTELLTEN PLATTENFÖRMIGEN STRUKTUR INSBESONDERE AUS SILIZIUM
METHOD OF PRODUCING A PLATE-SHAPED STRUCTURE, IN PARTICULAR, FROM SILICON, USE OF SAID METHOD AND PLATE-SHAPED STRUCTURE THUS PRODUCED, IN PARTICULAR FROM SILICON

(30) Priorité: 30.09.2003 FR 0311450
(43) Date de publication de la demande: 21.06.2006
(73) Titulaire: Tracit Technologies, 38430 Moirans (FR)
(72) Inventeur: BRUEL, Michel, F-38113 Veurey Voroize (FR)
(74) Mandataire: Casalonga, Axel
(86) Numéro de dépôt international: PCT/FR2004/002398
(87) Numéro de publication internationale: WO 2005/034218

(56) Documents cités:
- WO-A-01/03171
- US-A- 6 127 285
- US-B1- 6 417 075
- US-B1- 6 465 327

## Description

La présente invention concerne le domaine de la fabrication de plaques multicouches et de la fabrication de plaquettes fines.

Dans le domaine des microtechnologies, notamment, de la microélectronique et de l'opto-électronique, il est usuel d'utiliser des plaquettes de silicium accolées à une couche isolante et plus particulièrement des structures comprenant une couche isolante interposée entre un substrat en silicium et un superstrat en silicium.

US-B1-6 417 075 décrit un procédé de fabrication d'une telle structure multicouche contenant des cavités permettant la séparation par gravure d'une des couches.

La présente invention a pour objectif d'améliorer les techniques et les structures actuelles, d'en améliorer les performances et d'en diversifier les applications.

La présente invention a tout d'abord pour objet un procédé de fabrication d'une structure en forme de plaque comprenant au moins un substrat, un superstrat et au moins une couche intermédiaire interposée entre le substrat et le superstrat.

Selon la présente invention, ce procédé consiste à choisir une couche intermédiaire comprenant au moins un matériau de base dans lequel sont répartis des atomes ou molécules dits extrinsèques, différents des atomes ou molécules du matériau de base, et à appliquer un traitement thermique à ladite structure tel que, dans la plage de température de ce traitement thermique, la couche intermédiaire est plastiquement déformable, et la présence des atomes ou molécules extrinsèques choisis dans le matériau de base choisi engendre de façon irréversible la formation de micro-bulles ou micro-cavités dans la couche intermédiaire.

Selon la présente invention, le traitement thermique produit de préférence des micro-bulles ou micro-cavités d'affaiblissement de ladite couche intermédiaire.

Selon la présente invention, le traitement thermique produit de préférence une rupture de ladite couche intermédiaire et en conséquence une séparation du substrat et du superstrat.

La présente invention a également pour objet un procédé de séparation du substrat et du superstrat de la structure obtenue par le procédé ci-dessus.

Selon une variante de la présente invention, ce procédé de séparation peut consister à appliquer des forces entre le substrat et le superstrat de façon à produire la rupture de la couche intermédiaire entre le substrat et le superstrat grâce à la présence desdites micro-bulles ou micro-cavités.

Selon une autre variante de la présente invention, ce procédé de séparation peut consister à attaquer chimiquement la couche intermédiaire, de façon à obtenir l'enlèvement au moins partiel de cette couche intermédiaire entre le substrat et le superstrat grâce à la présence desdites micro-bulles ou micro-cavités.

Selon la présente invention, le substrat et le superstrat peuvent avantageusement être en silicium monocristallin et la couche intermédiaire peut avantageusement être en silice dopée.

La présente invention a également pour objet un procédé de fabrication de plaquettes en silicium qui consiste à réaliser une structure en forme de plaque comprenant un substrat en silicium, un superstrat en silicium et une couche intermédiaire diélectrique comprenant au moins un matériau de base dans lequel sont répartis des atomes ou molécules dits extrinsèques, différents des atomes ou molécules du matériau de base ; puis à appliquer un traitement thermique à ladite structure tel que, dans la plage de température du traitement thermique, la couche intermédiaire est plastiquement déformable et que la présence des atomes ou molécules extrinsèques choisis dans le matériau de base choisi engendre de façon irréversible la formation de micro-bulles ou micro-cavités dans la couche intermédiaire.

Selon la présente invention, ledit matériau de base est de préférence de la silice et les atomes extrinsèques sont de préférence des atomes de phosphore et/ou de bore formant ainsi une couche intermédiaire de phospho-silicate-glass (P.S.G.) ou de boro-phospho-silicate-glass (B.P.S.G.).

Selon la présente invention, la concentration du phosphore peut avantageusement être comprise entre 6% et 14%.

Selon la présente invention, la concentration de bore peut avantageusement être comprise entre 0 et 4%.

Selon la présente invention, le traitement thermique est de préférence réalisé à une température comprise entre 900 et 1200 °C.

Selon la présente invention, le procédé peut avantageusement consister, préalablement audit traitement thermique, à exécuter une opération de dépôt de ladite couche intermédiaire sur le substrat, respectivement le superstrat, et à attacher le superstrat, respectivement le substrat, à ladite couche intermédiaire par collage par adhésion moléculaire.

Selon la présente invention, le procédé peut avantageusement comporter une étape supplémentaire de réduction de l'épaisseur du substrat.

Selon la présente invention, le substrat et le superstrat peuvent avantageusement comporter respectivement, du côté de ladite couche intermédiaire, un oxyde thermique de silicium.

Selon une variante de la présente invention, le procédé peut avantageusement consister à exercer des forces sur ladite structure de façon à produire une rupture de ladite couche intermédiaire et en conséquence une séparation du substrat et du superstrat grâce à la présence desdites micro-bulles ou micro-cavités afin d'obtenir une plaquette constituée par le substrat et/ou une plaquette constituée par le superstrat.

Selon une variante de la présente invention, le procédé peut avantageusement consister à attaquer chimiquement ladite couche intermédiaire de ladite structure de façon à produire une séparation du substrat et du superstrat grâce à la présence desdites micro-bulles ou micro-cavités afin d'obtenir une plaquette de silicium constituée par le substrat et/ou une plaquette de silicium constituée par le superstrat.

Selon la présente invention, le procédé peut avantageusement consister à réaliser des parties en saillie dans le substrat et/ou le superstrat du côté de ladite couche intermédiaire.

Selon la présente invention, les parties en saillie sont de préférence rectilignes et s'étendent jusqu'aux bords de la structure.

Selon la présente invention, au moins certaines desdites micro-bulles ou micro-cavités sont de préférence à alvéoles ouvertes et constituent, au moins pour certaines d'entre elles, des canaux.

La présente invention a également pour objet un application du procédé à la fabrication de plaques de silicium sur isolant (S.O.I.) en vue de la fabrication de circuits électroniques intégrés et/ou de circuits opto-électroniques intégrés.

La présente invention a également pour objet une structure en forme de plaque comprenant au moins un substrat, un superstrat et au moins une couche intermédiaire interposée entre le substrat et le superstrat.

Selon la présente invention, ladite couche intermédiaire comprend au moins un matériau de base dans lequel sont répartis des atomes ou molécules dits extrinsèques, différents des atomes ou molécules du matériau de base, tels que, sous l'effet d'un traitement thermique, la couche intermédiaire devient plastiquement déformable et la présence des atomes ou molécules extrinsèques choisis dans le matériau de base choisi engendre de façon irréversible la formation de micro-bulles ou micro-cavités dans la couche intermédiaire.

Selon la présente invention, le substrat et le superstrat sont de préférence en silicium monocristallin et la couche intermédiaire est en silice dopée.

Selon la présente invention, le matériau de base est de préférence de la silice et les atomes extrinsèques sont de préférence des atomes de phosphore ou de bore formant ainsi une couche intermédiaire de phospho-silicate-glass (P.S.G.) ou de boro-phospho-silicate-glass (B.P.S.G.).

Selon la présente invention, la concentration du phosphore est de préférence comprise entre 8 et 14%.

Selon la présente invention, la concentration de bore est de préférence comprise entre 0 et 4%.

Selon la présente invention, le substrat et/ou le supertstrat présentent de préférence des parties en saillie dans ladite couche intermédiaire.

Selon la présente invention, les parties en saillie sont de préférence rectilignes et s'étendent jusqu'aux bords.

Selon la présente invention, au moins certaines desdites micro-bulles ou micro-cavités sont à alvéoles ouvertes et constituent, au moins pour certaines d'entre elles, des canaux.

La présente invention sera mieux comprise à l'étude de structures et de mode de fabrication de telles structures, décrits à titre d'exemples non limitatifs et représentés sur les dessins sur lesquels :
- la figure 1 représente une coupe transversale d'une structure selon l'invention, dans un état initial ;
- la figure 2 représente une coupe éclatée de la structure de la figure 1, en cours de fabrication ;
- la figure 3 représente une coupe de la structure de la figure 1, dans une étapre ultérieure de fabrication ;
- les figures 4 et 5 représentent une coupe de la structure de la figure 1, dans un état secondaire de fabrication ;
- et la figure 6 représente une variante de réalisation de la structure de la figure 1.

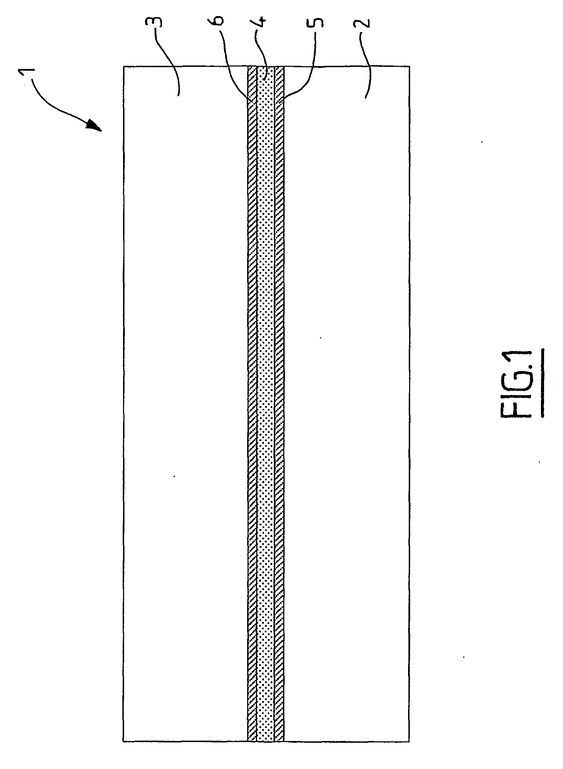

En se reportant à la figure 1, on peut voir qu'on a représenté une structure 1 en forme de plaque qui par exemple présente un diamètre d'environ deux cents millimètres.

Cette structure comprend un substrat 2 en forme de plaquette, un superstrat 3 en forme de plaquette et une couche intermédiaire 4 interposée entre le substrat 2 et le superstrat 3.

D'une manière générale, la couche intermédiaire 4 est en au moins un matériau de base dans lequel sont répartis des atomes ou molécules dits extrinsèques, différents des atomes ou molécules du matériau de base, et présente une composition telle que, lorsque l'on applique un traitement thermique adéquat à la structure 1, il se produit de façon irréversible une formation de micro-bulles ou de micro-cavités, en particulier d'une phase gazeuse, de telle sorte que cette couche intermédiaire 4 se transforme pour devenir spongieuse et corrélativement est susceptible d'augmenter en épaisseur.

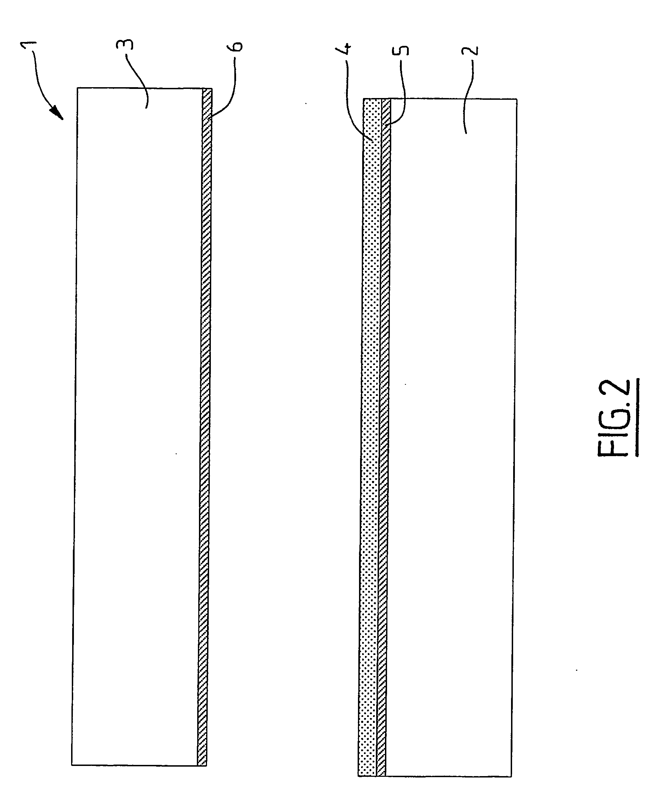

En se reportant à la figure 2, on va maintenant décrire un exemple de réalisation d'une structure 1.

Le substrat 2 peut être constitué par une plaquette de silicium monocristallin dont l'épaisseur peut être de quelques centaines de microns, par exemple comprise entre cinq cents et mille microns.

De façon optionnelle mais de préférence, on procède à l'obtention d'une pellicule 5 d'oxyde thermique de silicium sur une face du substrat 2.

Cette pellicule 5 peut être obtenue dans un four d'oxydation, à une température comprise entre 950 et 1100°C et peut présenter une épaisseur d'environ 0,5 micron.

Ensuite, on procède au dépôt, sur la face oxydée 5 du superstrat 2, d'une couche de silicium contenant ou dopé par un fort pourcentage de phosphore et/ou de bore, de façon à obtenir la couche intermédiaire 4 composée d'un matériau du type phospho-silicate-glass (PSG) ou de boro-phospho-silicate-glass (BPSG).

A titre d'exemple, le pourcentage de phosphore dans le matériau constituant la couche intermédiaire 4 peut être compris entre 6 et 14. Un tel dépôt peut être réalisé selon des techniques connues, dans des machines de dépôt de type CVD, LPCVD ou PECVD.

L'épaisseur de la couche intermédiaire 4 ainsi constituée peut présenter une épaisseur avoisinant les cinq microns.

De façon optionnelle mais de préférence, on peut faire subir à la surface de la couche intermédiaire 4 un traitement de nettoyage chimique, par exemple un nettoyage chimique de type RCA connu en soi.

De façon optionnelle mais de préférence, on peut réaliser, avant ou après le traitement de nettoyage, une opération de polissage mécano-chimique (CMP) de la couche intermédiaire 4.

De la même manière, le superstrat 3 peut être constitué par une plaquette de silicium présentant optionnellement une pellicule 6 d'oxyde thermique de silicium et ayant subi optionnellement un traitement de nettoyage chimique RCA et optionnellement une opération de polissage mécano-chimique (CRP).

De façon correspondante, la couche intermédiaire 4 aurait pu être réalisée sur la face oxydée 6 du superstrat 3.

Après quoi, on procède à l'assemblage du substrat 2 et du superstrat 3 en mettant la face oxydée 3 du superstrat 3 en contact sur la couche intermédiaire 4, de façon à obtenir un collage par adhésion moléculaire, éventuellement facilité par l'application d'efforts de préférence ponctuels d'appui entre le substrat 2 et le superstrat 3.

Pour éventuellement augmenter l'énergie de liaison interfaciale, on peut appliquer à la structure 1 ainsi assemblée un traitement thermique de consolidation, selon des conditions qui n'engendrent pas de transformation de la couche intermédiaie 4, c'est-à-dire de formations de micro-bulles ou de micro-cavités comme on le verra plus loin.

Ceci étant, on obtient une structure 1 composée d'un substrat 2 en silicium et d'un superstrat 3 en silicium séparés par une couche intermédiaire 4 en un matériau électriquement isolant.

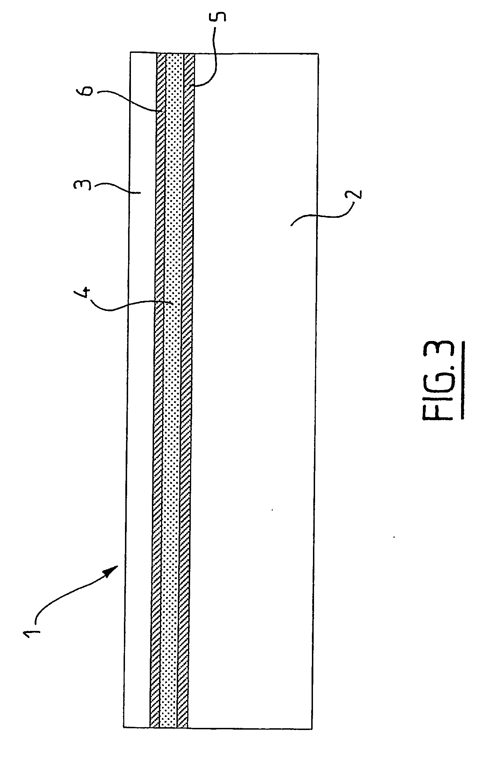

En se reportant à la figure 3, on peut voir que l'épaisseur du superstrat 3 peut être beaucoup plus petite que l'épaisseur du substrat 2 et peut être comprise entre une fraction de microns et quelques dizaines de microns.

Un tel substrat fin 3 peut être initialement utilisé pour la réalisation de la structure 1 comme on l'a décrit en référence à la figure 2.

Cependant, dans une variante, un tel superstrat fin 3 peut être obtenu par réduction de l'épaisseur d'un superstrat 3 épais pris initialement pour la réalisation de la structure 1 telle qu'on l'a décrite en référence à la figure 2. Une telle réduction d'épaisseur peut être obtenue au moyen des techniques connues de rectification, d'attaque chimique, ou de polissage mécano-chimique et peut aussi être obtenue par une technique de clivage, par exemple par le procédé connu aujourd'hui commercialement sous le nom de SMART-CUT^{®}, nécessitant une implantation ionique de protons à une dose de l'ordre de 5E16Cm-2 dans le superstrat 3 préalablement à la réalisation du collage par adhésion moléculaire prévu précédemment.

Une opération de réduction de l'épaisseur du substrat 2 pourrait également être réalisée.

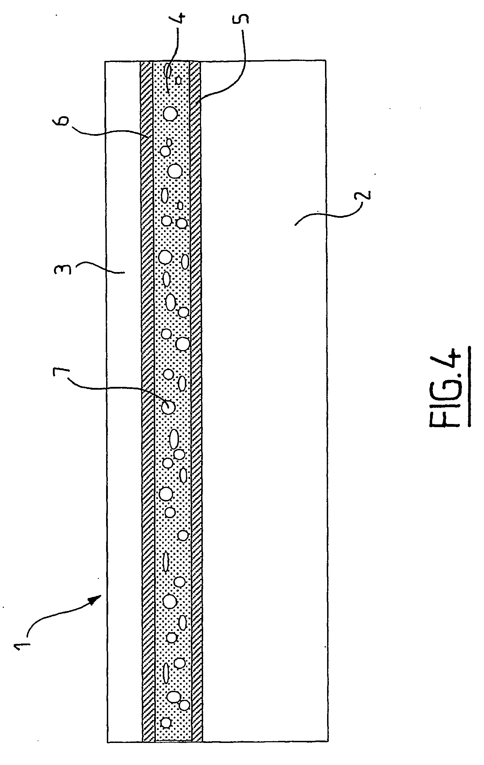

Comme le montre la figure 4, on peut alors faire subir à la structure 1 un traitement thermique dans un four, par exemple à une température comprise entre 900 et 1100°C.

Compte tenu des matériaux choisis précédemment mentionnés, l'application d'un tel traitement thermique, dans la plage de température choisie, rend la couche intermédiaire 4 plastiquement déformable et engendre de façon irréversible la formation d'une phase gazeuse constituée de micro-bulles ou micro-cavités 7 dans la couche intermédiaire 4 et corrélativement une augmentation de l'épaisseur de cette couche 4.

La quantité et le volume des micro-bulles ou micro-cavités 7 dépendent de la composition de la couche intermédiaire 4 et des conditions du traitement thermique appliqué à la structure 1.

A titre d'exemple, partant de cinq microns, l'épaisseur de la couche intermédiaire peut, après traitement, atteindre une épaisseur comprise entre quinze et vingt microns.

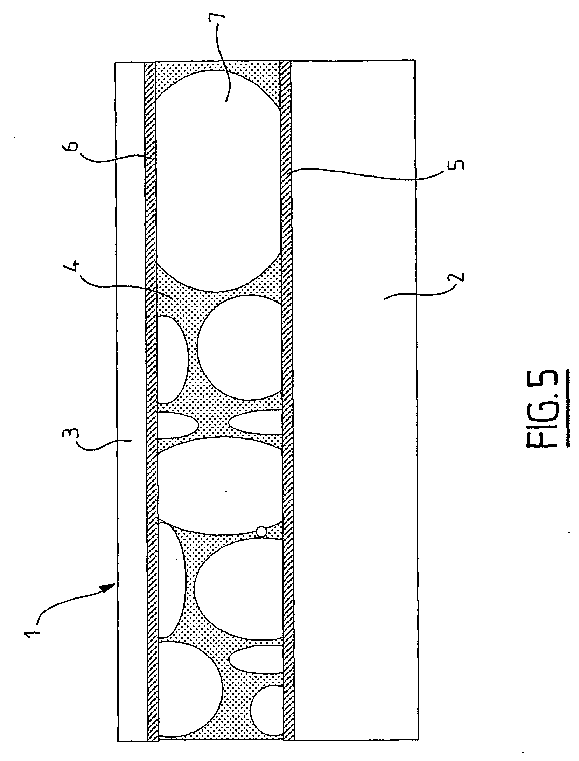

Comme le montre la figure 5, les micro-bulles ou micro-cavités 7 peuvent être d'un volume tel qu'elles sont ouvertes du côté des faces du substrat 2 et/ou du superstrat 3 et qu'elles peuvent en outre être ouvertes les unes vers les autres de façon à constituer des canaux ouverts sur les bords d'extrémité de la couche intermédiaire 4.

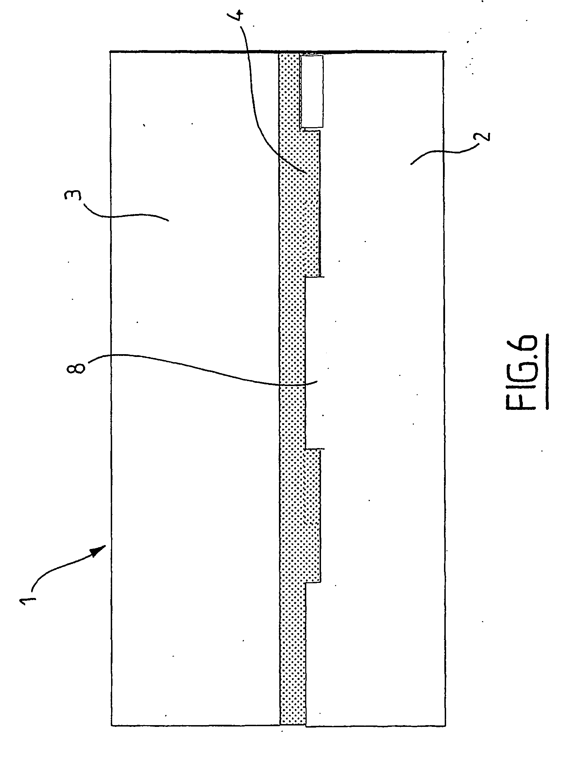

Comme le montre la figure 6, il peut être particulièrement avantageux de réaliser dans le substrat 2 et/ou dans le superstrat 3 des parties en saillie 8 de préférence rectilignes, par exemple par gravage, de telle sorte que ces parties en saillie 8 constituent des créneaux rectangulaires. Cette disposition peut faciliter l'apparition de micro-bulles ou micro-cavités 7 constituant les unes à la suite des autres des canaux.

La structure 1 qui vient d'être décrite, contenant des micro-bulles ou micro-cavités 7 dans sa couche intermédiaire 4, peut présenter de nombreuses applications.

Elle peut être utilisée telle quelle pour la réalisation de circuits intégrés électroniques ou opto-électroniques sur le superstrat 3 en silicium, montée sur un substrat épais 2 par l'intermédiaire de la couche intermédiaire 4 qui constitue un isolant électrique, la capacité entre la couche superficielle constituée par le superstrat 3 et la couche support constituée par le substrat 2 étant particulièrement faible du fait de la présence des micro-bulles ou micro-cavités 7.

Dans un autre exemple d'application, les canaux éventuellement mais volontairement créés dans la couche intermédiaire 4 par les micro-bulles ou micro-cavités 7 peuvent être utilisés pour la circulation d'un fluide de refroidissement entre le substrat 2 et le superstrat 3 dans le but de refroidir la structure 1.

Dans une autre application particulièrement avantageuse, la structure 1 contenant des micro-bulles ou micro-cavités 7 constitue une structure démontable du fait que la présence des micro-bulles ou des micro-cavités 7 dans la couche intermédiaire 4 affaiblit la résistance physique ou chimique de cette couche.

En effet, en appliquant des forces entre le substrat 2 et le superstrat 3, par tout moyen connu et par exemple par insertion d'une fine lame entre le substrat 2 et le superstrat 3 ou par un jet d'eau sous trait forte pression, on peut engendrer la rupture de la couche intermédiaire 4 et ainsi provoquer la séparation du substrat 2 qui alors constitue une plaquette et du superstrat 3 qui alors constitue une plaquette, par rupture de la matière de la couche intermédiaire 3 entre les micro-bulles ou les micro-cavités 7.

On peut aussi procéder à une attaque chimique de la couche intermédiaire 4 à partir de ses bords, par exemple au moyen d'une solution d'acides fluorhydrique, qui peut aisément progresser entre le substrat 2 et le superstrat 3 grâce à la présence des micro-bulles ou micro-cavités 7.

Ainsi, partant de la structure 1 décrite en référence à la figure 3, on aboutit à la réalisation d'une plaquette fine de silicium constituée par le superstrat fin 3.

La plaquette fine 3 de silicium ainsi obtenue peut être fixée par l'une ou l'autre de ses faces sur tout support final d'utilisation, par exemple en plastique afin de réaliser des circuits électroniques et/ou opto-électroniques souples.

La présente invention ne se limite pas aux exemples ci-dessus décrits. Bien des variantes de réalisation sont possibles sans sortir du cadre défini par les revendications annexées.

## Revendications

1. Procédé de fabrication d'une structure en forme de plaque comprenant au moins un substrat (2), un superstrat (3) et au moins une couche intermédiaire (4) interposée entre le substrat et le superstrat, **caractérisé par le fait qu'**il consiste à choisir une couche intermédiaire (4) comprenant au moins un matériau de base dans lequel sont répartis des atomes ou molécules dits extrinsèques, différents des atomes ou molécules du matériau de base, et qu'il consiste à appliquer un traitement thermique à ladite structure (1) tel que, dans la plage de température de ce traitement thermique, la couche intermédiaire est plastiquement déformable et la présence des atomes ou molécules extrinsèques choisis dans le matériau de base choisi engendre de façon irréversible la formation de micro-bulles ou micro-cavités (7) dans la couche intermédiaire.

2. Procédé selon la revendication 1, **caractérisé par le fait que** le traitement thermique produit des micro-bulles ou micro-cavités d'affaiblissement de ladite couche intermédiaire.

3. Procédé selon la revendication 1, **caractérisé par le fait que** le traitement thermique produit une rupture de ladite couche intermédiaire et en conséquence une séparation du substrat et du superstrat.

4. Procédé de séparation du substrat et du superstrat de la structure obtenue par le procédé selon l'une quelconque des revendications précédentes, **caractérisé par le fait qu'**il consiste à appliquer des forces entre le substrat (2) et le superstrat (3) de façon à produire la rupture de la couche intermédiaire entre le substrat et le superstrat grâce à la présence desdites micro-bulles ou micro-cavités.

5. Procédé de séparation du substrat et du superstrat de la structure obtenue par le procédé selon l'une quelconque des revendications 1 à 3, **caractérisé par le fait qu'**il consiste à attaquer chimiquement la couche intermédiaire (4) de la structure obtenue de façon à obtenir l'enlèvement au moins partiel de cette couche intermédiaire entre le substrat et le superstrat.

6. Procédé selon l'une quelconque des revendications précédentes, **caractérisé par le fait que** le substrat (2) et le superstrat (3) sont en silicium monocristallin et la couche intermédiaire (4) est en silice dopée.

7. Procédé de fabrication de plaquettes en silicium, **caractérisé par le fait qu'**il consiste :
- à réaliser une structure (1) en forme de plaque comprenant un substrat (2) en silicium, un superstrat (3) en silicium et une couche intermédiaire diélectrique (4) comprenant au moins un matériau de base dans lequel sont répartis des atomes ou molécules dits extrinsèques, différents des atomes ou molécules du matériau de base ;
- puis à appliquer un traitement thermique à ladite structure tel que, dans la plage de température du traitement thermique, la couche intermédiaire est plastiquement déformable et que la présence des atomes ou molécules extrinsèques choisis dans le matériau de base choisi engendre de façon irréversible 1a formation de micro-bulles ou micro-cavités (7) dans la couche intermédiaire (4).

8. Procédé selon la revendication 7, **caractérisé par le fait que** le matériau de base est de la silice et les atomes extrinsèques sont des atomes de phosphore ou de bore formant ainsi une couche intermédiaire de phospho-silicate-glass (P.S.G.) ou de boro-phospho-silicate-glass (B.P.S.G.).

9. Procédé selon la revendication 8, **caractérisé par le fait que** la concentration du phosphore est comprise entre 6% et 14%.

10. Procédé selon la revendication 8, **caractérisé par le fait que** la concentration de bore est comprise entre 0 et 4%.

11. Procédé selon l'une quelconque des revendications 7 à 10, **caractérisé par le fait que** le traitement thermique est réalisé à une température comprise entre 900 et 1200 °C .

12. Procédé selon l'une quelconque des revendications 7 à 11, **caractérisé par le fait qu'**il consiste, préalablement audit traitement thermique, à exécuter une opération de dépôt de ladite couche intermédiaire (4) sur le substrat (2), respectivement le superstrat (3), et à attacher le superstrat, respectivement le substrat, à ladite couche intermédiaire (4) par collage par adhésion moléculaire.

13. Procédé selon l'une quelconque des revendications 7 à 12, **caractérisé par le fait que** le substrat et le superstrat comportent respectivement, du côté de ladite couche intermédiaire (4), un oxyde thermique de silicium (5, 6).

14. Procédé selon l'une quelconque des revendications 7 à 13, **caractérisé par le fait qu'**il consiste à exercer des forces sur ladite structure (1) de façon à produire une rupture de ladite couche intermédiaire et en conséquence une séparation du substrat et du superstrat grâce à la présence desdites micro-bulles ou micro-cavités (7) afin d'obtenir une plaquette constituée par le substrat (2) et/ou une plaquette constituée par le superstrat (3).

15. Procédé selon l'une quelconque des revendications 7 à 14, **caractérisé par le fait qu'**il consiste à attaquer chimiquement ladite couche intermédiaire (4) de ladite structure (1) de façon à produire une séparation du substrat et du superstrat grâce à la présence desdites micro-bulles ou micro-cavités afin d'obtenir une plaquette constituée par le substrat (2) et/ou une plaquette constituée par le superstrat (3).

16. Procédé selon l'une quelconque des revendications précédentes, **caractérisé par le fait qu'**il consiste à réaliser des parties en saillie (8) dans le substrat (2) et/ou le superstrat (3) du côté de ladite couche intermédiaire (4).

17. Procédé selon l'une quelconque des revendications précédentes, **caractérisé par le fait que** les parties en saillie (8) sont rectilignes et s'étendent jusqu'aux bords de la couche intermédiaire (4).

18. Procédé selon l'une quelconque des revendications précédentes, **caractérisé par le fait qu'**au moins certaines desdites micro-bulles ou micro-cavités (7) sont à alvéoles ouvertes et constituent, au moins pour certaines d'entre elles, des canaux.

19. Procédé selon l'une quelconque des revendications précédentes, **caractérisé par le fait qu'**il comporte une étape supplémentaire de réduction de l'épaisseur dudit superstrat (3) et/ou du substrat.

20. Application du procédé selon l'une quelconque des revendications précédentes à la fabrication de plaques de silicium sur isolant (S.O.I.) en vue de la réalisation de circuits intégrés électroniques et/ou opto-électroniques.

21. Structure en forme de plaque comprenant au moins un substrat (2), un superstrat (3) et au moins une couche intermédiaire (4) interposée entre le substrat et le superstrat, **caractérisée par le fait que** ladite couche intermédiaire (4) comprend au moins un matériau de base dans lequel sont répartis des atomes ou molécules dits extrinsèques, différents des atomes ou molécules du matériau de base, tels que, sous l'effet d'un traitement thermique, la couche intermédiaire (4) devient plastiquement déformable et la présence des atomes ou molécules extrinsèques choisis dans le matériau de base choisi engendre de façon irréversible la formation de micro-bulles ou micro-cavités (7) dans la couche intermédiaire (4).

22. Structure selon la revendication 21, **caractérisée par le fait que** le substrat (2) et le superstrat (3) sont en silicium monocristallin et la couche intermédiaire (4) est en silice dopée.

23. Structure selon l'une des revendications 21 et 22, **caractérisée par le fait que** le matériau de base est de la silice et les atomes extrinsèques sont des atomes de phosphore ou de bore formant ainsi une couche intermédiaire de phospho-silicate-glass (P.S.G.) ou de boro-phospho-silicate-glass (B.P.S.G.).

24. Structure selon la revendication 23, **caractérisée par le fait que** la concentration du phosphore est comprise entre 8% et 14%.

25. Structure selon la revendication 23, **caractérisée par le fait que** la concentration de bore est comprise entre 0 et 4%.

26. Structure selon l'une quelconque des revendications 21 à 25, **caractérisée par le fait que** le substrat et/ou le supertstrat présentent des parties en saillie (8) dans ladite couche intermédiaire (4).

27. Structure selon la revendication 26, **caractérisée par le fait que** les parties en saillie (8) sont rectilignes et s'étendent jusqu'aux bords.

28. Structure selon l'une quelconque des revendications 21 à 27, **caractérisée par le fait qu'**au moins certaines desdites micro-bulles ou micro-cavités 7) sont à alvéoles ouvertes et constituent, au moins pour certaines d'entre elles, des canaux.

## Claims

1. Method for fabricating a structure in the form of a plate comprising at least one substrate (2), a superstrate (3) and at least one intermediate layer (4) interposed between the substrate and the superstrate, **characterized in that** it consists in selecting an intermediate layer (4) comprising at least one base material having distributed therein atoms or molecules termed extrinsic atoms or molecules which differ from the atoms or molecules of the base material, and applying a heat treatment to said structure (1) so that, in the temperature range of said heat treatment, the intermediate layer is plastically deformable and the presence of the selected extrinsic atoms or molecules in the selected base material causes the irreversible formation of microbubbles or microcavities (7) in the intermediate layer.

2. Method according to Claim 1, **characterized in that** the heat treatment produces microbubbles or microcavities which weaken said intermediate layer.

3. Method according to Claim 1, **characterized in that** the heat treatment produces a rupture of said intermediate layer and, as a result, separation of the substrate and the superstrate.

4. Method for separating the substrate and superstrate in the structure obtained by the method according to any one of the preceding claims, **characterized in that** it consists in applying forces between the substrate (2) and the superstrate (3) to bring about the rupture of the intermediate layer between the substrate and the superstrate due to the presence of said microbubbles or microcavities.

5. Method for separating the substrate and superstrate in the structure obtained by the method according to any one of Claims 1 to 3, **characterized in that** it consists in chemically etching the intermediate layer (4) of the structure to at least partially remove said intermediate layer between the substrate and the superstrate.

6. Method according to any one of the preceding claims, **characterized in that** the substrate (2) and the superstrate (3) are formed from monocrystalline silicon and the intermediate layer (4) is formed from doped silica.

7. Method for fabricating silicon wafers, **characterized in that** it consists in:
• producing a structure (1) in the form of a plate comprising a substrate (2) formed from silicon, a superstrate (3) formed from silicon and a dielectric intermediate layer (4) comprising at least one base material having distributed therein atoms or molecules termed extrinsic atoms or molecules which differ from the atoms or molecules of the base material;
• then applying a heat treatment to said structure so that, in the temperature range of the heat treatment, the intermediate layer is plastically deformable and so that the presence of the selected extrinsic atoms or molecules in the selected base material causes the irreversible formation of microbubbles or microcavities (7) in the intermediate layer (4).

8. Method according to Claim 7, **characterized in that** the base material is formed from silica and the extrinsic atoms are atoms of phosphorus or boron, thus forming an intermediate layer of phosphosilicate glass (PSG) or borophosphosilicate glass (BPSG).

9. Method according to Claim 8, **characterized in that** the concentration of phosphorus is in the range from 6% to 14%.

10. Method according to Claim 8, **characterized in that** the concentration of boron is in the range from 0% to 4%.

11. Method according to any one of Claims 7 to 10, **characterized in that** the heat treatment is carried out at a temperature in the range from 900°C to 1200°C.

12. Method according to any one of Claims 7 to 11, **characterized in that** it consists, prior to said heat treatment, in carrying out an operation for depositing said intermediate layer (4) on the substrate (2), or respectively the superstrate (3), and attaching the superstrate, or respectively the substrate, to said intermediate layer (4) by molecular wafer bonding.

13. Method according to any one of Claims 7 to 12, **characterized in that**, on the intermediate layer (4) side, the substrate and the superstrate respectively comprise a thermal silicon oxide (5, 6).

14. Method according to any one of Claims 7 to 13, **characterized in that** it consists in exerting forces on said structure (1) in a manner such that rupture of said intermediate layer is brought about, resulting in separation of the substrate and superstrate due to the presence of said microbubbles or microcavities (7) to obtain a wafer constituted by the substrate (2) and/or a wafer constituted by the superstrate (3).

15. Method according to any one of Claims 7 to 14, **characterized in that** it consists in chemically attacking said intermediate layer (4) of said structure (1) to bring about separation of the substrate and superstrate due to the presence of said microbubbles or microcavities to obtain a wafer constituted by the substrate (2) and/or a wafer constituted by the superstrate (3).

16. Method according to any one of the preceding claims, **characterized in that** it consists in producing projecting portions (8) in the substrate (2) and/or the superstrate (3) on said intermediate layer (4) side.

17. Method according to any one of the preceding claims, **characterized in that** the projecting portions (8) are rectilinear and extend to the sides of the intermediate layer (4).

18. Method according to any one of the preceding claims, **characterized in that** at least some of said microbubbles or microcavities (7) are open-celled and at least some thereof constitute channels.

19. Method according to any one of the preceding claims, **characterized in that** it comprises a supplemental step of reducing the thickness of said superstrate (3) and/or substrate.

20. Application of the method according to any one of the preceding claims to the fabrication of silicon-on-insulator (SOI) plates for the fabrication of integrated electronic circuits and/or integrated optoelectronic circuits.

21. Structure in the form of a plate comprising at least one substrate (2), a superstrate (3) and at least one intermediate layer (4) interposed between the substrate and the superstrate, **characterized in that** said intermediate layer (4) comprises at least one base material having distributed therein atoms or molecules termed extrinsic atoms or molecules which differ from the atoms or molecules of the base material so that, under the effect of a heat treatment, the intermediate layer (4) becomes plastically deformable and the presence of the selected extrinsic atoms or molecules in the selected base material causes the irreversible formation of microbubbles or microcavities (7) in the intermediate layer (4).

22. Structure according to Claim 21, **characterized in that** the substrate (2) and the superstrate (3) are formed from monocrystalline silicon and the intermediate layer (4) is formed from doped silica.

23. Structure according to either of Claims 21 and 22, **characterized in that** the base material is silica and the extrinsic atoms are atoms of phosphorus or boron, thus forming an intermediate layer of phosphosilicate glass (PSG) or borophosphosilicate glass (BPSG).

24. Structure according to Claim 23, **characterized in that** the concentration of phosphorus is in the range from 8% to 14%.

25. Structure according to Claim 23, **characterized in that** the concentration of boron is in the range from 0% to 4%.

26. Structure according to any one of Claims 21 to 25, **characterized in that** the substrate and/or the superstrate have portions (8) projecting into said intermediate layer (4).

27. Structure according to Claim 26, **characterized in that** the projecting portions (8) are rectilinear and extend to the sides.

28. Structure according to any one of Claims 21 to 27, **characterized in that** at least some of said microbubbles or microcavities (7) are open-celled and at least some thereof constitute channels.

## Patentansprüche

1. Verfahren zur Herstellung einer plattenförmigen Struktur, die mindestens ein Substrat (2), ein Superstrat (3) und wenigstens eine zwischen dem Substrat und dem Superstrat eingefügte Zwischenschicht (4) enthält, **dadurch gekennzeichnet, dass** zu dem Verfahren die Schritte gehören: Auswählen einer Zwischenschicht (4), die mindestens ein Basismaterial enthält, in dem als Störstellen bezeichnete Atome oder Moleküle verteilt sind, die sich von Atomen oder Molekülen des Basismaterials unterscheiden, und Unterziehen der Struktur (1) einer Wärmebehandlung, so dass die Zwischenschicht in dem Temperaturbereich dieser Wärmebehandlung plastisch verformbar ist, und die Anwesenheit der ausgewählten Störstellenatome oder -moleküle in dem ausgewählten Basismaterial irreversibel die Entstehung von Mikroblasen oder Mikrohohlräumen (7) in der Zwischenschicht hervorruft.

2. Verfahren nach Anspruch 1, **dadurch gekennzeichnet, dass** die Wärmebehandlung schwächende Mikroblasen oder Mikrohohlräume der Zwischenschicht erzeugt.

3. Verfahren nach Anspruch 1, **dadurch gekennzeichnet, dass** die Wärmebehandlung einen Bruch der Zwischenschicht und infolgedessen eine Trennung des Substrats und des Superstrats hervorruft.

4. Verfahren zur Trennung des Substrats und des Superstrats der durch das Verfahren nach einem der vorhergehenden Ansprüche gewonnenen Struktur, **dadurch gekennzeichnet, dass** zu dem Verfahren der Schritt gehört, zwischen dem Substrat (2) und dem Superstrat (3) Kräfte auszuüben, um infolge der vorhandenen Mikroblasen oder Mikrohohlräume den Bruch der Zwischenschicht zwischen dem Substrat und dem Superstrat hervorzurufen.

5. Verfahren zur Trennung des Substrats und des Superstrats der durch das Verfahren nach einem der vorhergehenden Ansprüche 1 bis 3 gewonnenen Struktur, **dadurch gekennzeichnet, dass** zu dem Verfahren der Schritt gehört, die Zwischenschicht (4) der gewonnenen Struktur chemisch zu ätzen, um eine zumindest teilweise Entfernung dieser zwischen dem Substrat und dem Superstrat angeordneten Zwischenschicht zu erreichen.

6. Verfahren nach einem der vorhergehenden Ansprüche, **dadurch gekennzeichnet, dass** das Substrat (2) und das Superstrat (3) auf monokristallinem Silizium basieren, und dass die Zwischenschicht (4) auf dotiertem Siliziumdioxid basiert.

7. Verfahren zur Herstellung von Siliziumplättchen, **dadurch gekennzeichnet, dass** zu dem Verfahren die Schritte gehören:
- Verwirklichung einer plattenförmigen Struktur (1), die ein auf Silizium basierendes Substrat (2), ein auf Silizium basierendes Superstrat (3) und eine dielektrische Zwischenschicht (4) aufweist, die mindestens ein Basismaterial umfasst, in dem als Störstellen bezeichnete Atome oder Moleküle verteilt sind, die sich von Atomen oder Molekülen des Basismaterials unterscheiden;
- anschließendes Unterzeihen der Struktur einer Wärmebehandlung, so dass die Zwischenschicht in dem Temperaturbereich der Wärmebehandlung plastisch verformbar ist, und dass die Anwesenheit der ausgewählten Störstellenatome oder -moleküle in dem ausgewählten Basismaterial irreversibel die Entstehung von Mikroblasen oder Mikrohohlräumen (7) in der Zwischenschicht (4) hervorruft.

8. Verfahren nach Anspruch 7, **dadurch gekennzeichnet, dass** das Basismaterial auf Siliziumdioxid basiert und die Störstellenatome Phosphor- oder Boratome sind, die auf diese Weise eine Zwischenschicht von Phosphorsilikatglas (P.S.G.) oder von Bor-Phosphorsilikatglas (B.P.S.G.) bilden.

9. Verfahren nach Anspruch 8, **dadurch gekennzeichnet, dass** der Phosphoranteil zwischen 6 und 14 % beträgt.

10. Verfahren nach Anspruch 8, **dadurch gekennzeichnet, dass** der Boranteil zwischen 0 und 4 % beträgt.

11. Verfahren nach einem der Ansprüche 7 bis 10, **dadurch gekennzeichnet, dass** die Wärmebehandlung bei einer Temperatur zwischen 900 und 1200°C durchgeführt wird.

12. Verfahren nach einem der Ansprüche 7 bis 11, **dadurch gekennzeichnet, dass** zu dem Verfahren die Schritte gehören, vor der Wärmebehandlung einen Schritt der Abscheidung der Zwischenschicht (4) auf dem Substrat (2) bzw. auf dem Superstrat (3) auszuführen, und das Superstrat bzw. das Substrat an der Zwischenschicht (4) mittels Haftung durch molekulare Adhäsion anzubringen.

13. Verfahren nach einem der Ansprüche 7 bis 12, **dadurch gekennzeichnet, dass** das Substrat und das Superstrat auf der der Zwischenschicht (4) zugewandten Seite jeweils ein thermisches Siliziumoxid (5, 6) aufweisen.

14. Verfahren nach einem der Ansprüche 7 bis 13, **dadurch gekennzeichnet, dass** zu dem Verfahren der Schritt gehört, Kräfte auf die Struktur (1) auszuüben, um einen Bruch der Zwischenschicht und infolgedessen wegen der vorhandenen Mikroblasen oder Mikrohohlräume (7) eine Trennung des Substrats und des Superstrats hervorzurufen, um ein durch das Substrat (2) gebildetes Plättchen/Scheibe und/oder ein durch das Superstrat (3) gebildetes Plättchen/Scheibe zu erhalten.

15. Verfahren nach einem der Ansprüche 7 bis 14, **dadurch gekennzeichnet, dass** zu dem Verfahren der Schritt gehört, die Zwischenschicht (4) der Struktur (1) chemisch zu ätzen, um infolge der vorhandenen Mikroblasen oder Mikrohohlräume eine Trennung des Substrats und des Superstrats hervorzurufen, um ein durch das Substrat (2) gebildetes Plättchen/Scheibe und/oder ein durch das Superstrat (3) gebildetes Plättchen/Scheibe zu erhalten.

16. Verfahren nach einem der vorhergehenden Ansprüche, **dadurch gekennzeichnet, dass** zu dem Verfahren der Schritt gehört, in dem Substrat (2) und/oder in dem Superstrat (3) auf der der Zwischenschicht (4) zugewandten Seite erhabene Abschnitte (8) zu erzeugen.

17. Verfahren nach einem der vorhergehenden Ansprüche, **dadurch gekennzeichnet, dass** die erhabenen Abschnitte (8) geradlinig sind und sich bis zu den Rändern der Zwischenschicht (4) erstrecken.

18. Verfahren nach einem der vorhergehenden Ansprüche, **dadurch gekennzeichnet, dass** wenigstens gewisse der Mikroblasen oder Mikrohohlräume (7) offene Zellen sind und zumindest für bestimmte unter diesen Kanäle bilden.

19. Verfahren nach einem der vorhergehenden Ansprüche, **dadurch gekennzeichnet, dass** das Verfahren einen zusätzlichen Schritt einer Reduzierung der Dicke des Superstrats (3) und/oder des Substrats aufweist.

20. Verwendung des Verfahrens nach einem der vorhergehenden Ansprüche zur Herstellung von Scheiben aus Silizium auf Isolator (S.O.I.) mit Blick auf die Herstellung elektronischer und/oder optoelektronischer integrierter Schaltkreise.

21. Plattenförmige Struktur, die mindestens ein Substrat (2), ein Superstrat (3) und wenigstens eine zwischen dem Substrat und dem Superstrat eingefügte Zwischenschicht (4) enthält, **dadurch gekennzeichnet, dass** die Zwischenschicht (4) mindestens ein Basismaterial enthält, in dem als Störstellen bezeichnete Atome oder Moleküle verteilt sind, die sich von Atomen oder Molekülen des Basismaterials unterscheiden, so dass die Zwischenschicht (4) unter der Wirkung einer Wärmebehandlung plastisch verformbar ist, und die Anwesenheit der ausgewählten Störstellenatome oder -moleküle in dem ausgewählten Basismaterial irreversibel die Entstehung von Mikroblasen oder Mikrohohlräumen (7) in der Zwischenschicht (4) hervorruft.

22. Struktur nach Anspruch 21, **dadurch gekennzeichnet, dass** das Substrat (2) und das Superstrat (3) auf monokristallinem Silizium basieren, und dass die Zwischenschicht (4) auf dotiertem Siliziumdioxid basiert.

23. Struktur gemäß einem der Ansprüche 21 und 22, **dadurch gekennzeichnet, dass** das Basismaterial auf Siliziumdioxid basiert und die Störstellenatome auf Phosphor- oder Boratomen basieren, die auf diese Weise eine auf Phosphorsilikatglas (P.S.G.) oder auf Bor-Phosphorsilikatglas (B.P.S.G.) basierende Zwischenschicht bilden.

24. Struktur nach Anspruch 23, **dadurch gekennzeichnet, dass** der Phosphoranteil zwischen 8 und 14 % beträgt.

25. Struktur nach Anspruch 23, **dadurch gekennzeichnet, dass** der Boranteil zwischen 0 und 4 % beträgt.

26. Struktur nach einem der Ansprüche 21 bis 25, **dadurch gekennzeichnet, dass** das Substrat und/oder das Superstrat vorspringende Abschnitte (8) in der Zwischenschicht (4) aufweisen.

27. Struktur nach Anspruch 26, **dadurch gekennzeichnet, dass** die vorspringenden Abschnitte (8) geradlinig sind und sich bis zu den Rändern erstrecken.

28. Struktur nach einem der Ansprüche 21 bis 27, **dadurch gekennzeichnet, dass** wenigstens gewisse der Mikroblasen oder Mikrohohlräume (7) auf offenen Zellen basieren und zumindest für bestimmte unter diesen Kanäle bilden.
